# EUROPEAN PATENT SPECIFICATION

(11) **EP 2 112 871 B1**
(45) Date of publication and mention of the grant of the patent: **13.07.2016**
(21) Application number: 08251484.5
(22) Date of filing: 22.04.2008
(51) Int. Cl.: H05K 1/02

(54) **Circuit board with improved ground layer**
Leiterplatte mit verbesserter Erdungsschicht
Carte de circuit imprimé avec une couche de terre améliorée

(43) Date of publication of application: 28.10.2009
(73) Proprietor: Hon Hai Precision Industry Co., Ltd., Tu-cheng City, Taipei Hsien (TW)
(72) Inventor: Lin, Yu-Hsu, Tu-Cheng City Taipei Hsien (TW); Wu, Jeng-Da, Tu-Cheng City Taipei Hsien (TW); Chao, Chih-Hang, Tu-Cheng City Taipei Hsien (TW)
(74) Representative: Huang, Chongguang

(56) References cited:
- EP-A- 1 720 384
- WO-A-2007/099596
- JP-A- 6 326 476
- US-A- 5 360 949
- US-A1- 2006 144 616
- US-A1- 2008 151 521

## Description

The present invention relates to a circuit board, particularly to a circuit board with an improved ground layer.

Circuit boards such as printed circuit boards (PCBs) are widely used in conventional electronic devices. In designing a contemporary PCB, controlling trace impedance is very important. The impedance relates to a number of parameters, such as the widths and distances of signal traces, and the thicknesses of media/insulating layers of the PCB. For example, a circuit board includes a signal plane/layer with signal traces arranged thereon and a ground layer/layer with ground traces arranged thereon. A media layer is disposed between the signal plane and the ground layer. Generally, the thickness of the media layer is so thin, that the impedance of the signal traces is reduced too much. That may affect the signal quality of the circuit board.

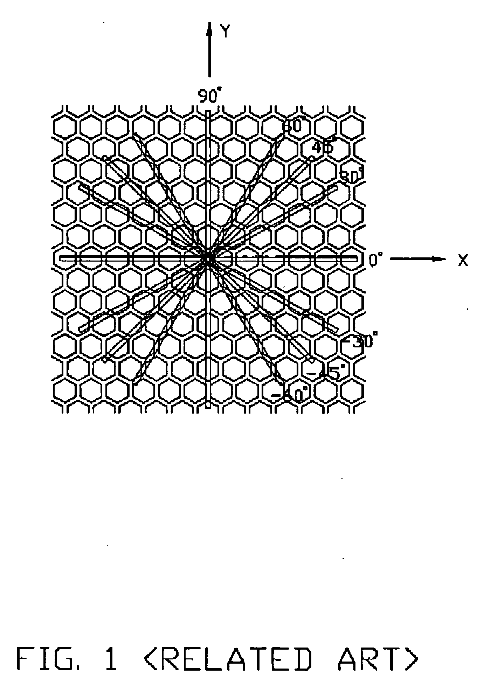

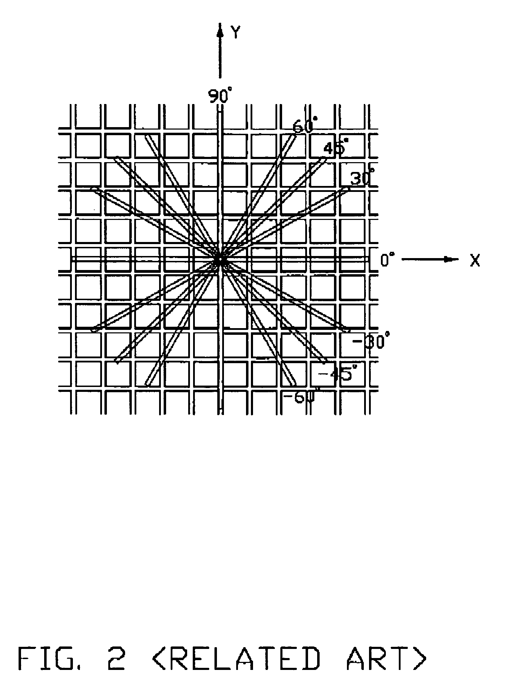

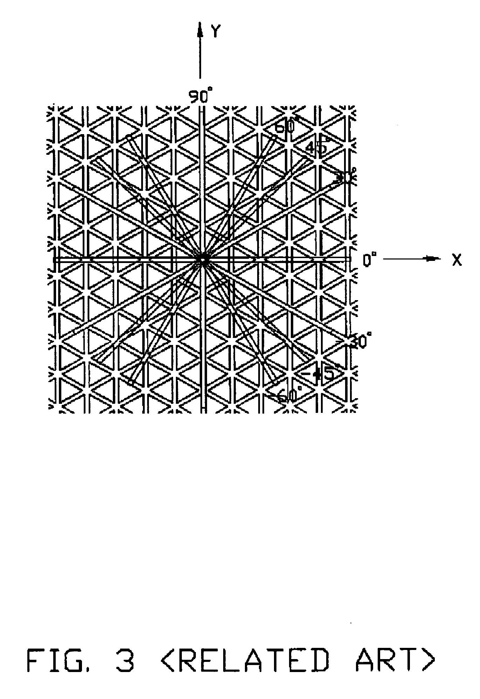

Conventionally, in order to achieve a desired signal impedance of the circuit board, the ground traces of the ground layer/layer are typically formed and arranged in a fashion, e.g. an array of same-sized equilateral hexagons, squares, or equilateral triangles (as shown in Figs. 1-3). The ground layer defines an X-axis along which a straight line segment of a signal trace is arranged. Generally, each straight line segment of a signal trace is arranged on the signal plane at an angle of 0, 30,45, 60, 90, -30, -45 or -60 degrees relative to an X-axis of the ground layer (as shown in Figs 1-3). The ground traces are also arranged at angles of 0, 30, 45, 60, 90, -30, -45 or -60 degrees relative to the X-axis of the ground layer. In designing a PCB using the preceding arrangement, some line segments of a signal trace will cross ground traces of the ground layer at an angle causing only slight variation in impedance of the signal trace. However, to the detriment of signal trace performance, some portion or portions of a signal trace line segment will be overlap with straight linear portion of a ground trace or traces of the ground layer, causing the impedance of that portion or portions of the signal trace line segment to be greatly reduced. Thus, the impedance of the signal trace will vary unevenly to effect signal quality. WO-A-2007/099596 discloses a wiring board, US-A-5360949 discloses a printed circuit board and JP-A-06326476 discloses a multilayered wiring board.

What is needed, therefore, is a circuit board having proper signal trace impedance for improving signal quality.

Thus viewed from one aspect the present invention provides a circuit board comprising:
a media layer having a first surface and an opposite second surface;
a signal layer formed on the first surface, the signal layer comprising a plurality of signal traces arranged thereon for transmitting signals therethrough, each of the signal traces comprising a plurality of straight line signal trace segments; and
a ground layer formed on the second surface, the ground layer comprising a ground trace network for being grounded, the ground trace network comprising a plurality of linear ground trace segments which cooperatively form a plurality of closed grounding loops, a projection of each of the straight line signal trace segments on the ground layer intersecting a plurality of the grounding loops and not overlapping any of the linear ground trace segments of the intersected grounding loops, thereby minimizing interaction between the linear ground traces and the signal traces; wherein each of the grounding loops is a polygon in shape; and
a main plane of the ground layer defines an X-axis along which some of the straight line signal trace segments of one of the signal traces are oriented and a Y-axis perpendicular to the X-axis, the projection of the straight line signal trace segments of each signal trace on the ground layer being at angles of 0, 30, 45, 60, 90, -30, -45, or -60 degrees relative to the X-axis, a Y'-axis being defined by a straight line passing through one ground trace segment of one loop, wherein the Y'-axis is inclined relative to the Y-axis at 22.5 degrees.

A circuit board is provided for improving signal quality, including a signal layer and a ground layer. The signal layer includes a plurality of signal traces arranged thereon for transmitting signals therethrough. Each of the signal traces includes a plurality of straight line signal trace segments. The ground layer includes a ground trace network for being grounded. The ground trace network includes a plurality of linear ground trace segments. The linear ground trace segments cooperatively form a plurality of closed grounding loops. A projection of each of the straight line signal trace segments on the ground layer intersect a plurality of the grounding loops and does not overlap any of the linear ground trace segments of the intersected grounding loops, thereby minimizing interaction between the linear ground traces and the signal traces.

Other advantages and novel features of the present invention will become more apparent from the following detailed description of preferred embodiment when taken in conjunction with the accompanying drawings, in which:
FIG 1 is a top view of a first embodiment of a conventional ground layer of a circuit board, with straight line segments of signal traces mapped thereon;
FIG. 2 is a top view of a second embodiment of a conventional ground layer of a circuit board, with straight lines segment of signal traces mapped thereon;
FIG 3 is a top view of a third embodiment of a conventional ground layer of a circuit board, with straight line segments of signal traces mapped thereon;
FIG 4 is a cut-away view of a circuit board in accordance with a preferred embodiment, including a signal layer with a plurality of signal traces arranged thereon, a ground layer, and a media layer disposed therebetween;
FIG 5 is a top view of a first embodiment of a ground layer of a circuit board in accordance with a preferred embodiment, with straight line segments of signal traces mapped thereon;
FIG 6 is a top view of a second embodiment of a ground layer of a circuit board in accordance with a preferred embodiment, with straight line segments of signal traces mapped thereon;
FIG 7 is a top view of a third embodiment of a ground layer of a circuit board in accordance with a preferred embodiment, with straight line segments of signal traces mapped thereon;
FIG 8 is a top view of a fourth embodiment of a ground layer of a circuit board in accordance with a preferred embodiment, with straight line segments of signal traces mapped thereon;
FIG. 9 is a top view of a fifth embodiment of a ground layer of a circuit board in accordance with a preferred embodiment, with straight line segments of signal traces mapped thereon; and
FIG. 10 is a top view of a sixth embodiment of a ground layer of a circuit board in accordance with a preferred embodiment, with straight line segments of signal traces mapped thereon.

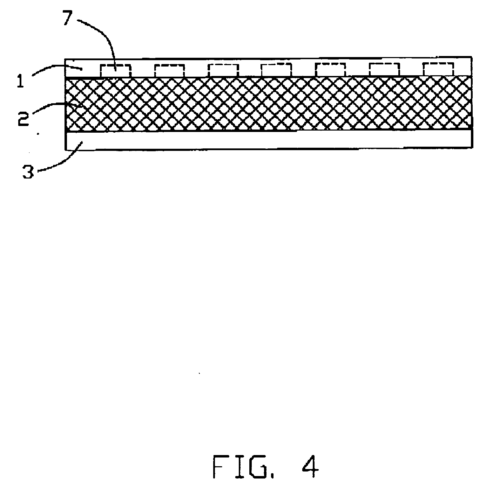

Referring to FIG 4, which shows a circuit board with a ground layer for improving the signal quality, the circuit board in accordance with a preferred embodiment includes a signal layer 1 with a plurality of signal traces 7 arranged thereon and a ground layer 3 for a plurality of ground traces arranged thereon. Each signal trace 7 includes a plurality of straight line segments. A media layer 2 is disposed between the signal layer 1 and the ground layer 3. The media layer 2 may be a dielectric layer.

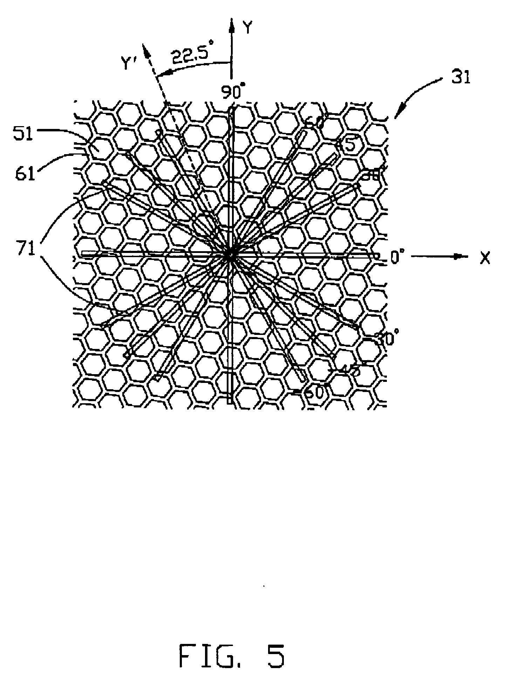

Referring to FIG 5, a ground layer 31 in accordance with a first embodiment of the present invention is shown. The ground layer 31 includes a ground trace network formed by a plurality of closed grounding loops 51 for being grounded. Each grounding loop 51 is a polygon delimited by six equal linear ground traces 61 connected consecutively end-to-end, forming an equilateral hexagon-shaped loop 51. The ground layer 31 defines an X-axis along which a straight line signal trace segment 71 of a signal trace 7 is arranged. A Y-axis of the ground layer 31 is perpendicular to the X-axis. A straight line passing through one linear ground trace 61 of each grounding loop 51 is designated as a Y'-axis of the grounding loop 51. In the present embodiment, the Y'-axis of each grounding loop 51 is rotated 22.5 degrees relative to the Y-axis of the ground layer 31. Thus, the ground traces 61 are oriented on the ground layer 31 at angles of 22.5, 52.5, 67.5, 112.5, -7.5, -22.5, or -37.5 degrees relative to the X-axis of the ground layer 31. Each straight line signal trace segment 71 of the signal traces 7 is arranged on the signal layer 1 at an angle of 0, 30, 45, 60, 90, -30, -45 or -60 degrees relative to the X-axis of the ground layer 31. Thus, different portions of each straight line signal trace segment 71 of the signal trace 7 mapped on the ground layer 31 are at an angle of at least 7.5 degrees relative to any given ground trace 61 they cross. That is, a projection of each of the straight line signal trace segments 71 on the ground layer 31 intersects the ground loops 51. With this arrangement, interaction between the ground traces and the signal traces is minimized to reduce differences in impedances of the signal traces and cause the impedance of segments of the signal traces to vary evenly, thereby greatly improving signal quality. Wherein the ground traces 61 on the ground layer 31 may be oriented at other angles relative to the ground layer 31 to ensure segments of the signal traces 7 are not coincident with the ground traces 61.

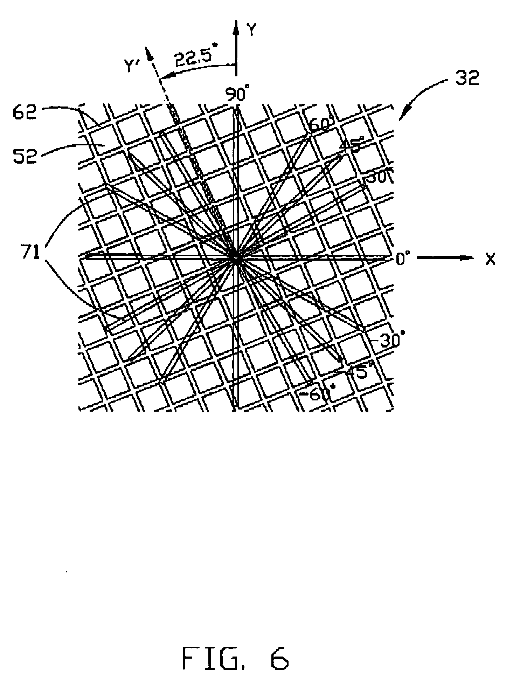

Referring to Fig. 6, a ground layer 32 of a circuit board in accordance with a second embodiment is shown. The ground layer 32 of the second embodiment is similar to that of Fig.5, but each grounding loop 52 of the present embodiment is a polygon delimited by four equal linear ground traces 62 connected consecutively end-to-end, forming a closed square grounding loop. A Y'-axis of each grounding loop 52 is defined by a straight line passing through one linear ground trace 62 of the square grounding loops. The Y'-axis of are rotated 22.5 degrees relative to the Y-axis of the ground layer 32.

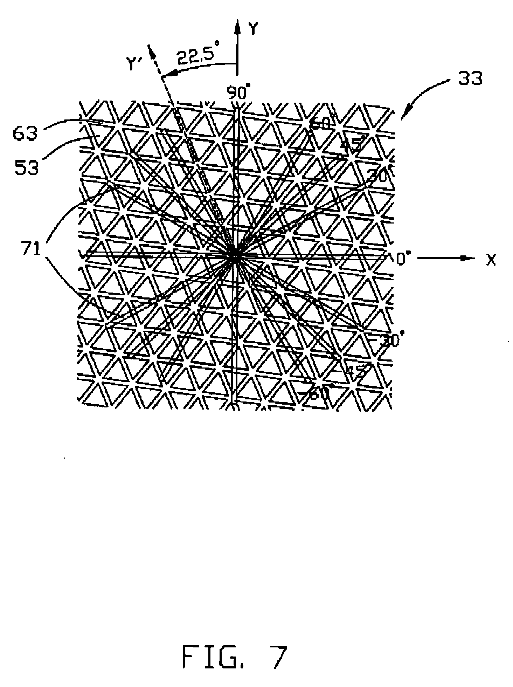

Referring to Fig. 7, a ground layer 33 of a circuit board in accordance with a third embodiment is shown. The ground layer 33 of the third embodiment is similar to that of Fig.5, but each grounding loop 53 of the present embodiment is a polygon delimited by three equal linear ground traces 63 connected consecutively end-to-end, forming a triangle-shaped grounding loop. A Y'-axis of each grounding loop 53 is defined by a straight line passing through one linear ground trace 63 of the triangle-shaped grounding loops 53. The Y'-axis are rotated 22.5 degrees relative to the Y-axis of the ground layer 33.

Wherein the grounding loops of the ground layer could be other polygonal shapes formed by ground traces which are oriented on the ground layer at angles to ensure segments of the signal traces are not coincident with the ground traces.

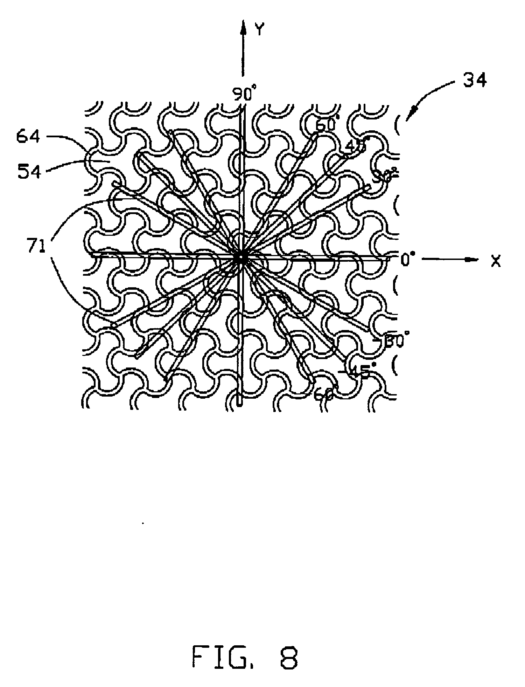

Referring to FIG 8, a ground layer 34 of a circuit board in accordance with a fourth embodiment is shown. In this embodiment, the ground layer 34 includes a plurality of same-sized grounding loops 54 with six rounded convex corners and rounded concave sides. Each grounding loop 54 is formed by curved ground traces 64.

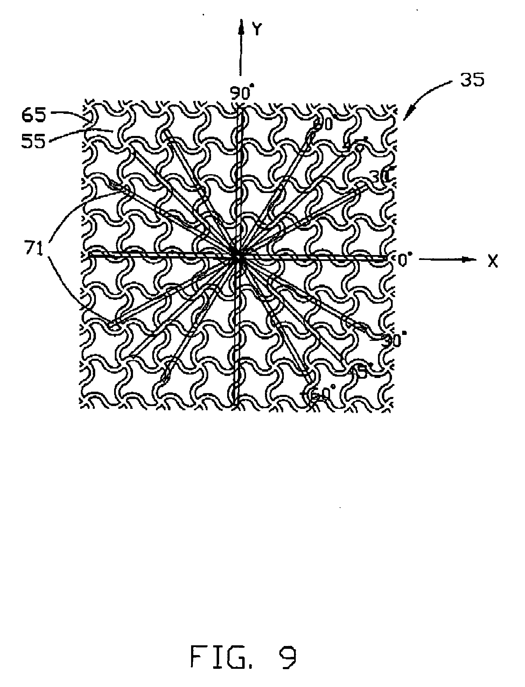

Referring to FIG. 9, a ground layer 35 of a circuit board in accordance with a fifth embodiment is shown. In this embodiment, the ground layer 35 includes a plurality of same-sized grounding loops 55 with four wavy sides. Each grounding loop 55 is formed by curved ground traces 65.

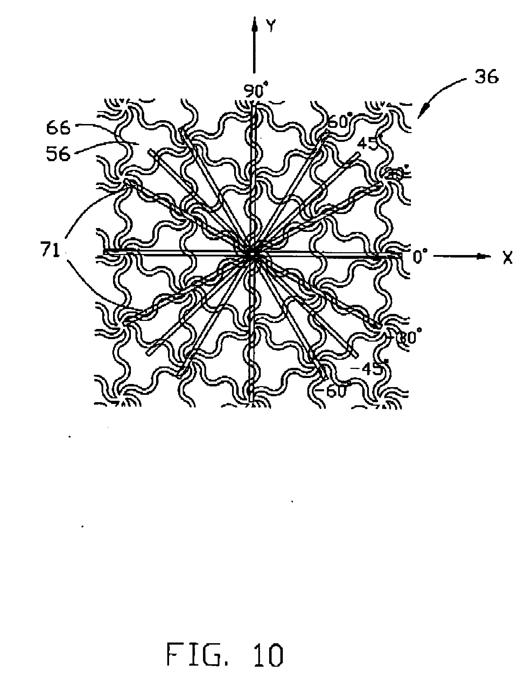

Referring to FIG. 10, a ground layer 36 of a circuit board in accordance with a sixth embodiment is shown. In this embodiment, the ground layer 36 includes a plurality of same-sized grounding loops 56 with three wavy sides. Each grounding loop 56 is formed by curve ground traces 66.

According to the above, different portions of each line segment of a signal trace mapped on the ground layer will cross any given ground trace at a similar angle since the grounding loops are formed by curved ground traces. With this arrangement, interaction between the ground traces and the signal traces is minimized to reduce differences in impedances of the signal traces and cause the impedance of segments of the signal traces to vary evenly, thereby greatly improving signal quality. Wherein the grounding loops of the ground layer may be formed as other shapes by curved ground traces.

## Claims

1. A circuit board comprising:
a media layer (2) having a first surface and an opposite second surface;
a signal layer (1) formed on the first surface, the signal layer (1) comprising a plurality of signal traces (7) arranged thereon for transmitting signals therethrough, each of the signal traces (7) comprising a plurality of straight line signal trace segments (71); and
a ground layer (3, 31-36) formed on the second surface, the ground layer (3, 31-36) comprising a ground trace network for being grounded, the ground trace network comprising a plurality of linear ground trace segments (61-63), the linear ground trace segments (61-63) cooperatively forming a plurality of closed grounding loops (51-53), a projection of each of the straight line signal trace segments (71) on the ground layer (3, 31-36) intersecting a plurality of the grounding loops (51-53) and not overlapping any of the linear ground trace segments (61-63) of the intersected grounding loops (51-53), thereby minimizing interaction between the linear ground traces and the signal traces (7);
wherein each of the grounding loops (51-53) is a polygon in shape; **characterised by** a main plane of the ground layer (3, 31-36) defines an X-axis along which some of the straight line signal trace segments (71) of one of the signal traces (7) are oriented, and a Y-axis perpendicular to the X-axis, the projection of the straight line signal trace segments (71) of each signal trace on the ground layer (3, 31-36) being at angles of 0, 30, 45, 60, 90, -30, -45, or -60 degrees relative to the X-axis, a Y'-axis being defined by a straight line passing through one ground trace segment of one loop, and the Y'-axis being inclined relative to the Y-axis at 22.5 degrees.

2. The circuit board as described in claim 1, wherein each of the grounding loops (51-53) is an equilateral polygon in shape.

3. The circuit board as described in claim 1, wherein the projection of each of the straight line signal trace segments (71) on the ground layer (3, 31-36) obliquely intersects the intersected linear ground trace segments (61-63) of the intersected grounding loops (51-53) at an angle of at least about 7.5 degrees.

4. The circuit board as described in claim 1, wherein the grounding loops (51-53) forms a regular repeated pattern.

5. The circuit board as described in claim 1, wherein the projection of each of the straight line signal trace segments (71) on the ground layer (3, 31-36) is not parallel to any of the linear ground trace segments (61-63) of the intersected grounding loops (51-53).

## Patentansprüche

1. Leiterplatte mit:
einer Medienschicht (2), die eine erste Oberfläche und eine gegenüberliegende zweite Oberfläche aufweist;
einer Signalschicht (1), die auf der ersten Oberfläche ausgebildet ist, wobei die Signalschicht (1) mehrere Signalleiterbahnen (7) aufweist, die darauf angeordnet sind, um Signale darüber zu übertragen, wobei jede der Signalleiterbahnen (7) mehrere geradlinige Signalleiterbahnsegmente (71) umfasst; und
einer Erdungsschicht (3, 31-36), die auf der zweiten Oberfläche ausgebildet ist, wobei die Erdungsschicht (3, 31-36) ein Netz aus Erdungsleiterbahnen umfasst, um geerdet zu werden, wobei das Netz aus Erdungsleiterbahnen mehrere lineare Erdungsleiterbahnsegmente (61-63) umfasst, wobei die linearen Erdungsleiterbahnsegmente (61-63) kooperativ mehrere geschlossenen Erdungsschleifen (51-53) bilden, wobei eine Projektion eines jeden der geradlinigen Signalleiterbahnsegmente (71) auf die Erdungsschicht (3, 31-36) mehrere der Erdungsschleifen (51-53) schneidet und nicht mit irgendeinem der linearen Leiterbahnsegmente (61-63) der geschnittenen Erdungsschleifen (51-53) überlappt, wodurch die Interaktion zwischen den linearen Erdungsleiterbahnen und den Signalleiterbahnen (7) minimiert wird;
wobei jeder der Erdungsschleifen (51-53) von der Form her ein Polygon ist;
**dadurch gekennzeichnet, dass**
eine Hauptebene der Erdungsschicht (3, 31-36) eine X-Achse, entlang der einige der geradlinigen Signalleiterbahnensegmente (71) von einer der Signalleiterbahnen (7) ausgerichtet sind, und eine Y-Achse rechtwinklig zu der X-Achse definiert, wobei die Projektion der geradlinigen Signalleiterbahnsegmente (71) von jeder Signalleiterbahn auf die Erdungsschicht (3, 31-36) in Winkeln von 0, 30, 45, 60, 90, -30, -45 oder -60 Grad relativ zu der X-Achse ist, wobei eine Y'-Achse als eine gerade Linie definiert ist, die durch ein Erdungsleiterbahnsegment von einer Schleife läuft, und wobei die Y'-Achse relativ zu der Y-Achse um 22,5 Grad geneigt ist.

2. Leiterplatte nach Anspruch 1, wobei jede der Erdungsschleifen (51 - 53) von der Form her ein gleichseitiges Polygon ist.

3. Leiterplatte nach Anspruch 1, wobei die Projektion von jedem der geradlinigen Signalleiterbahnensegmente (71) auf die Erdungsschicht (3, 31-36) schräg die geschnittenen, linearen Erdungsleiterbahnsegmente (61-63) der geschnittenen Erdungsschleifen (51-53) in einem Winkel von zumindest ungefähr 7,5 Grad schneidet.

4. Leiterplatte nach Anspruch 1, wobei die Erdungsschleifen (51-53) ein regelmäßiges, wiederholtes Muster bilden.

5. Leiterplatte nach Anspruch 1, wobei die Projektion von jedem der geradlinigen Signalleiterbahnensegmente (71) auf die Erdungsschicht (3, 31-36) nicht parallel zu irgendeinem der linearen Erdungsleiterbahnensegmente (61-63) der geschnittenen Erdungsschleifen (51-53) ist.

## Revendications

1. Carte de circuit imprimé comprenant :
une couche de milieu (2) présentant une première surface et une seconde surface opposée ;
une couche de signal (1) formée sur la première surface, la couche de signal (1) comprenant une pluralité de pistes de signal (7) agencées sur celle-ci pour transmettre des signaux à travers celle-ci,
chacune des pistes de signal (7) comprenant une pluralité de segments de piste de signal en ligne droite (71) ; et
une couche de masse (3, 31-36) formée sur la seconde surface, la couche de masse (3, 31-36) comprenant un réseau de pistes de masse pour une mise à la masse, le réseau de pistes de masse comprenant une pluralité de segments de piste de masse linéaires (61-63), les segments de piste de masse linéaires (61-63) formant par coopération une pluralité de boucles fermées de mise à la masse (51-53), une projection de chacun des segments de piste de signal en ligne droite (71) sur la couche de masse (3, 31-36) croisant une pluralité des boucles de mise à la masse (51-53) et ne chevauchant aucun des segments de piste de masse linéaires (61-63) des boucles de mise à la masse croisées (51-53), minimisant ainsi l'interaction entre les pistes de masse linéaires et les pistes de signal (7) ;
dans laquelle chacune des boucles de mise à la masse (51-53) est en forme de polygone ;
**caractérisée en ce qu'**un plan principal de la couche de masse (3, 31-36) définit un axe des X le long duquel certains des segments de piste de signal en ligne droite (71) d'une des pistes de signal (7) sont orientés, et un axe des Y perpendiculaire à l'axe des X, la projection des segments de piste de signal en ligne droite (71) de chaque piste de signal sur la couche de masse (3, 31-36) étant à des angles de 0, 30, 45, 60, 90, -30, -45, ou -60 degrés par rapport à l'axe des X, un axe des Y' étant défini par une ligne droite traversant un segment de piste de masse d'une boucle, et l'axe des Y' étant incliné par rapport à l'axe des Y à 22,5 degrés.

2. Carte de circuit imprimé selon la revendication 1, dans laquelle chacune des boucles de mise à la masse (51-53) est en forme de polygone équilatéral.

3. Carte de circuit imprimé selon la revendication 1, dans laquelle la projection de chacun des segments de piste de signal en ligne droite (71) sur la couche de masse (3, 31-36) croise de manière oblique les segments de piste de masse linéaires croisés (61-63) des boucles de mise à la masse croisées (51-53) à un angle supérieur ou égal à 7,5 degrés.

4. Carte de circuit imprimé selon la revendication 1, dans laquelle les boucles de mise à la masse (51-53) forment un motif régulier répété.

5. Carte de circuit imprimé selon la revendication 1, dans laquelle la projection de chacun des segments de piste de signal en ligne droite (71) sur la couche de masse (3, 31-36) n'est parallèle avec aucun des segments de piste de masse linéaires (61-63) des boucles de mise à la masse croisées (51-53).
